# EUROPEAN PATENT APPLICATION

(11) **EP 4 657 742 A1**
(43) Date of publication of application: **03.12.2025**
(21) Application number: 24747291.3
(22) Date of filing: 23.01.2024
(51) Int. Cl.: H02M 7/48, H05K 1/02

(54) **PRINTED CIRCUIT BOARD, AND AIR CONDITIONING DEVICE HAVING SAME**

(30) Priority: 27.01.2023 JP 2023010744
(71) Applicant: Daikin Industries, Ltd., Osaka-shi, Osaka 530-0001 (JP)
(72) Inventor: FUKUSHIMA, Teruhisa, Osaka-shi, Osaka 530-0001 (JP); HIROTA, Naohito, Osaka-shi, Osaka 530-0001 (JP); UEDA, Narushige, Osaka-shi, Osaka 530-0001 (JP); OKAMOTO, Shuhei, Osaka-shi, Osaka 530-0001 (JP); AOKI, Masahiro, Osaka-shi, Osaka 530-0001 (JP)
(74) Representative: Hoffmann Eitle
(86) International application number: PCT/JP2024/001812
(87) International publication number: WO 2024/157964

(57) **Abstract**

An object of the present disclosure is to provide a printed circuit board that prevents breakage of a lead of a mounted component due to vibration of a heavy component on a substrate. A printed circuit board (100) includes a first component (10) that is a heavy component that accumulates electric energy or inductive energy, a second component (20) that is a power device having a plurality of leads (200), and a substrate (30) on which a first component (10) and a second component (20) are mounted. In the substrate (30), a slit (30a) is provided between the first component (10) and the second component (20), and a lead of the second component (20) is soldered. In the printed circuit board (100), the slit (30a) suppresses propagation of vibration from the heavy first component (10) to the second component (20), thereby preventing the leads (200) from breaking due to the vibration.

## Description

### TECHNICAL FIELD

The present disclosure relates to a printed circuit board.

### BACKGROUND ART

A slit may be provided around a component mounted on a substrate for the purpose of reducing an influence on the substrate when an impact or vibration is applied to the component. For example, in a printed circuit board described in Patent Literature 1 (JP H4-107875 U), a discontinuous slit is provided to surround an attachment portion of a transformer that is a heavy component, and expansion of cracks is prevented.

### SUMMARY OF THE INVENTION

### <Technical Problem>

When vibration repeatedly acts on the substrate, the vibration of the heavy component may propagate to a component away from the heavy component, and a lead of the component may be broken.

However, in Patent Literature 1, no response is made to vibration from a heavy component causing breakage of the lead of a mounted component.

### <Solution to Problem>

A printed circuit board according to a first aspect includes a first component, a second component, and a substrate. The first component is a heavy component that accumulates electric energy or inductive energy. The second component is a power device having a plurality of leads. On the substrate, the first component and the second component are mounted, a slit is provided between the first component and the second component, and a lead of the second component is soldered.

In this printed circuit board, the slit, which suppresses propagation of vibration from the heavy first component to the second component, prevents breakage of the lead due to the vibration.

A printed circuit board according to a second aspect is the printed circuit board according to the first aspect, in which a plurality of leads includes a first lead closest to the first component. The slit is provided between the first component and the first lead.

In this printed circuit board, the slit suppresses propagation of vibration from the heavy first component to the second component, thereby preventing the first lead closest to the first component from breaking.

A printed circuit board according to a third aspect is the printed circuit board according to the second aspect, in which stress on the first lead by the first component is larger than stress on another component when vibration in a direction perpendicular to the substrate is applied.

A printed circuit board according to a fourth aspect is the printed circuit board according to any one of the first to third aspects, in which the plurality of first components is mounted on the substrate. The plurality of first components includes a first heavy component. The first heavy component is a heavy component having the largest stress on the lead when vibration in a direction perpendicular to the substrate is applied. The slit is provided between the first heavy component and the second component.

A printed circuit board according to a fifth aspect is the printed circuit board according to any one of the first to fourth aspects, in which the first component is any of an electrolytic capacitor, a reactor, or a coil.

A printed circuit board according to a sixth aspect is the printed circuit board according to any one of the first to fifth aspects, in which the second component is any of an intelligent power module, an active filter module, an insulated gate bipolar transistor, a MOSFET, a diode, a thyristor, or a triac.

A printed circuit board according to a seventh aspect is the printed circuit board according to any one of the first to sixth aspects, in which the first component is mounted at a central portion of the substrate.

In this printed circuit board, since the first component is located at the central portion of the substrate, the substrate is easily distorted by vibration. Therefore, providing a slit in the substrate is highly effective.

A printed circuit board according to an eighth aspect is the printed circuit board according to any one of the first to seventh aspects, in which the slit penetrates the substrate.

A printed circuit board according to a ninth aspect is the printed circuit board according to any one of the first to eighth aspects, in which a width of the slit is in a range of 1.0 mm to 4.0 mm.

This printed circuit board can satisfy both workability of the slit and prevention of vibration propagation.

A printed circuit board according to a tenth aspect is the printed circuit board according to any one of the first to ninth aspects, in which the substrate is fixed to an object via the coupling member and the second component.

In this printed circuit board, since the lead of the second component also functions as a coupling member, the lead is susceptible to repeated fatigue due to vibration as compared with other mounted components. Therefore, a slit is provided between the first component and the second component to block vibration propagation and protect the lead from repeated fatigue.

An air conditioner according to an eleventh aspect includes the printed circuit board according to any one of the first to tenth aspects.

### BRIEF DESCRIPTION OF THE DRAWINGS

FIG. 1 is a perspective view of an air conditioner including a printed circuit board of the present disclosure.
FIG. 2 is a circuit diagram of a power conversion circuit included in the printed circuit board of the present disclosure.
FIG. 3 is an internal perspective view of an electric component box when the inside of the electric component box is viewed from a direction in which a first surface of the printed circuit board is a front surface.
FIG. 4 is an external view of the printed circuit board when the printed circuit board shown in FIG. 3 is viewed from the direction in which the first surface is the front surface.
FIG. 5 is an external view of the printed circuit board when the printed circuit board shown in FIG. 3 is viewed from a direction in which a second surface is the front surface.
FIG. 6 is a schematic sectional view of the electric component box which accommodates the printed circuit board in FIG. 3.
FIG. 7 is an external view of the printed circuit board in which the shape of a slit in FIG. 5 is modified when the printed circuit board is viewed from the direction in which the second surface is the front surface.
FIG. 8 is an external view of the printed circuit board in which the number of the slits in FIG. 7 is changed when the printed circuit board is viewed from the direction in which the second surface is the front surface.

### DESCRIPTION OF EMBODIMENTS

### (1) Configuration of printed circuit board 100

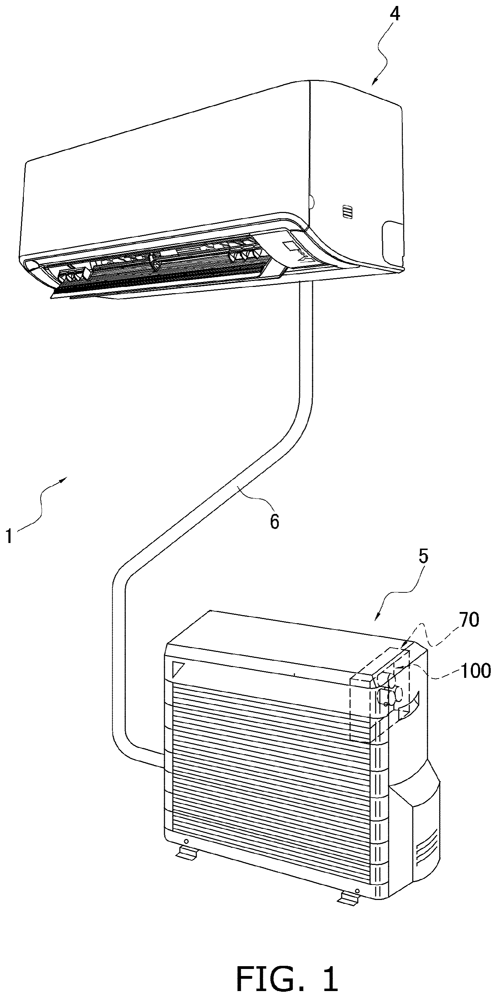

FIG. 1 is a perspective view of an air conditioner 1 including a printed circuit board 100 of the present disclosure. In FIG. 1, the air conditioner 1 includes an indoor unit 4 and an outdoor unit 5. The indoor unit 4 and the outdoor unit 5 are connected by a refrigerant connection pipe 6.

The indoor unit 4, the outdoor unit 5, and the refrigerant connection pipe 6 constitute a refrigerant circuit. In the refrigerant circuit, for example, a vapor compression refrigeration cycle is repeated during a cooling operation, a heating operation, and a dehumidifying operation.

The indoor unit 4 is attached to an indoor wall, although not necessarily, and alternatively, may be installed on a ceiling or a floor.

The outdoor unit 5 is installed outdoors and functions as a heat source unit that supplies heat energy to the indoor unit 4.

An electric component box is mounted on the indoor unit 4 and the outdoor unit 5, and a printed circuit board is accommodated in the electric component box. Here, the printed circuit board 100 of the outdoor unit 5 will be described as an example.

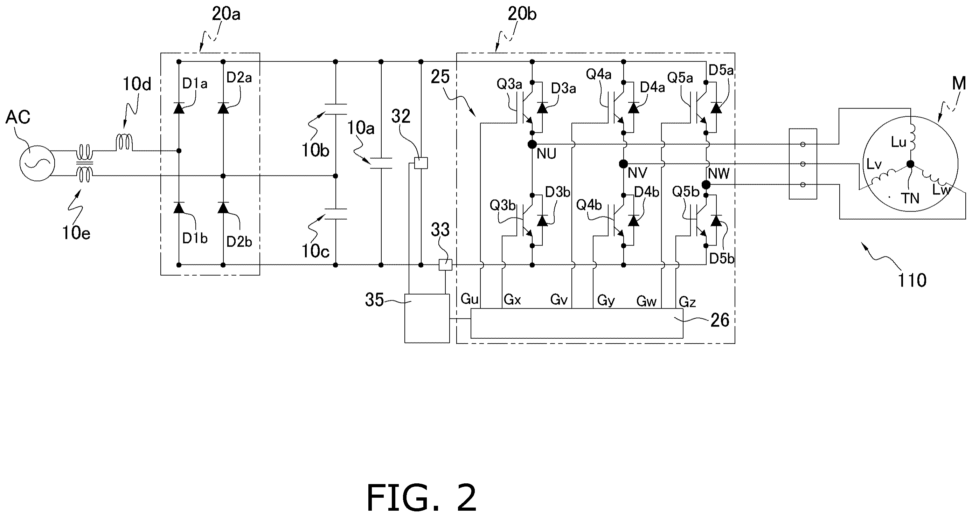

FIG. 2 is a circuit diagram of a power conversion circuit 110 included in the printed circuit board 100 of the present disclosure.

In FIG. 2, the power conversion circuit 110 rectifies AC power into DC power, converts the DC power into AC power having a predetermined frequency, and supplies the AC power to a motor M. The motor M drives a compressor provided in the refrigerant circuit of the air conditioner 1, for example.

### (1-1) Rectifying diode module 20a

The rectifying diode module 20a includes four diodes D1a, D1b, D2a, and D2b to constitute a bridge. Specifically, the diodes D1a and D1b are connected in series, and the diodes D2a and D2b are connected in series.

A connection point of the diode D1a and the diode D1b is connected to one pole of an AC power source AC. A connection point of the diode D2a and the diode D2b is connected to another pole of the alternating current power source AC.

The rectifying diode module 20a rectifies AC power output from the alternating current power source AC to generate DC power, and supplies the DC power to first to third electrolytic capacitors 10a to 10c.

### (1-2) First to third electrolytic capacitors 10a to 10c

The first to third electrolytic capacitors 10a to 10c smooth a voltage rectified by the rectifying diode module 20a.

The second electrolytic capacitor 10b and the third electrolytic capacitor 10c are connected in series, perform smoothing and output a double voltage, and constitute a double voltage rectifier circuit together with a diode bridge rectifier circuit of the rectifying diode module 20a.

The voltage smoothed by the first to third electrolytic capacitors 10a to 10c is supplied to an intelligent power module 20b.

### (1-3) Reactor 10d

As shown in FIG. 2, a reactor 10d is provided on an AC power source line, and has one end connected to an input side (coil 10e) of the alternating current power source AC and the other end connected to the diode bridge rectifier circuit of the rectifying diode module 20a. Functions of the reactor 10d include power factor improvement and harmonic suppression.

### (1-4) Coil 10e

The coil 10e is connected between the alternating current power source AC and the reactor 10d. The coil 10e is a common mode choke coil that removes common mode noise.

### (1-5) Intelligent power module 20b

The intelligent power module 20b incorporates a switching circuit 25 and a control circuit 26, and is formed into one package. Hereinafter, the intelligent power module 20b is referred to as an "IPM 20b".

### (1-5-1) Switching circuit 25

In the switching circuit 25, three upper and lower arms individually corresponding to U-phase, V-phase, and W-phase drive coils Lu, Lv, and Lw of the motor M are connected to an output side of the first electrolytic capacitor 10a in parallel to each other.

In FIG. 2, the switching circuit 25 includes a plurality of insulated gate bipolar transistors (IGBTs, hereinafter, simply referred to as transistors) Q3a, Q3b, Q4a, Q4b, Q5a, and Q5b, and a plurality of reflux diodes D3a, D3b, D4a, D4b, D5a, and D5b.

The transistors Q3a and Q3b, the transistors Q4a and Q4b, and the transistors Q5a and Q5b are respectively connected in series to constitute upper and lower arms, and output wires extend from connection points NU, NV, and NW thus formed to the drive coils Lu, Lv, and Lw for the corresponding phases.

The diodes D3a to D5b are respectively connected in parallel with the transistors Q3a to Q5b with a collector terminal of each transistor connected to a cathode terminal of the corresponding diode and an emitter terminal of each transistor connected to an anode terminal of the corresponding diode.

The switching circuit 25 generates a drive voltage for driving the motor M by applying a DC voltage and turning on and off the transistors Q3a to Q5b at a timing instructed by the control circuit 26. This drive voltage is outputted from the connection points NU, NV, and NW of the transistors Q3a and Q3b, Q4a and Q4b, and Q5a and Q5b to the drive coils Lu, Lv, and Lw of the motor M.

### (1-5-2) Control circuit 26

The control circuit 26 changes on and off states of the transistors Q3a to Q5b of the switching circuit 25 on the basis of a command voltage from an inverter microcomputer 35.

Specifically, the control circuit 26 generates gate control voltages Gu, Gx, Gv, Gy, Gw, and Gz such that a pulse drive voltage having any duty ratio is outputted from the switching circuit 25 to the motor M. The duty ratio is determined by the inverter microcomputer 35.

The generated gate control voltages Gu, Gx, Gv, Gy, Gw, and Gz are respectively applied to gate terminals of the transistors Q3a to Q5b.

### (1-6) Inverter microcomputer 35

The inverter microcomputer 35 is connected to a voltage detector 32, a current detector 33, and the control circuit 26. The inverter microcomputer 35 also monitors a detection value of the voltage detector 32, and performs protection control to turn off the transistors Q3a to Q5b when the detection value of the voltage detector 32 exceeds a predetermined threshold value.

### (2) Component arrangement on printed circuit board 100

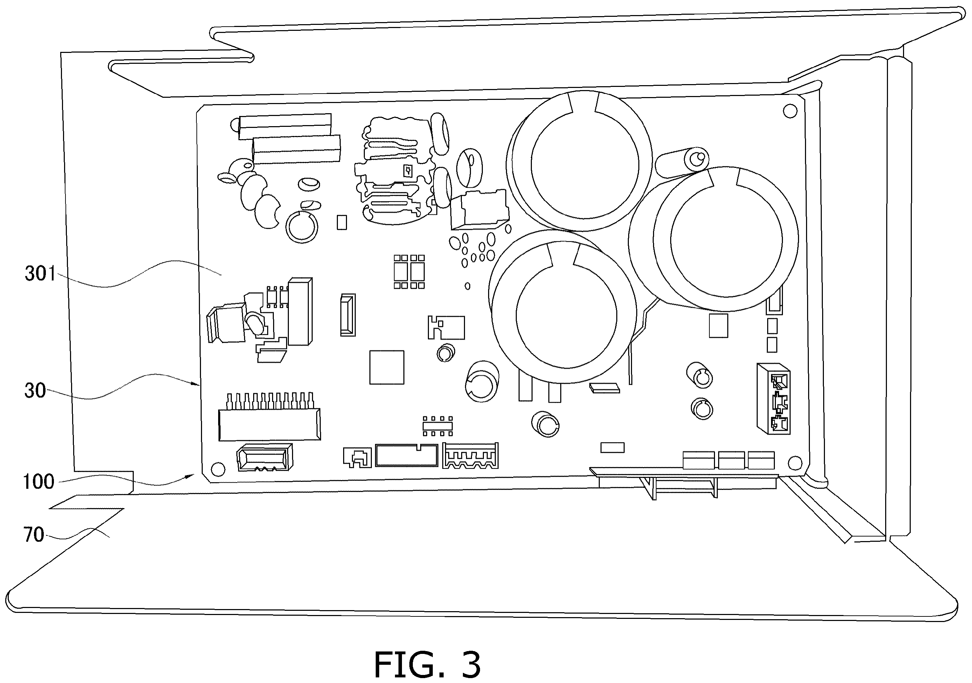

FIG. 3 is an internal perspective view of an electric component box 70 when the inside of the electric component box 70 is viewed from a direction in which a first surface 301 of the printed circuit board 100 is a front surface.

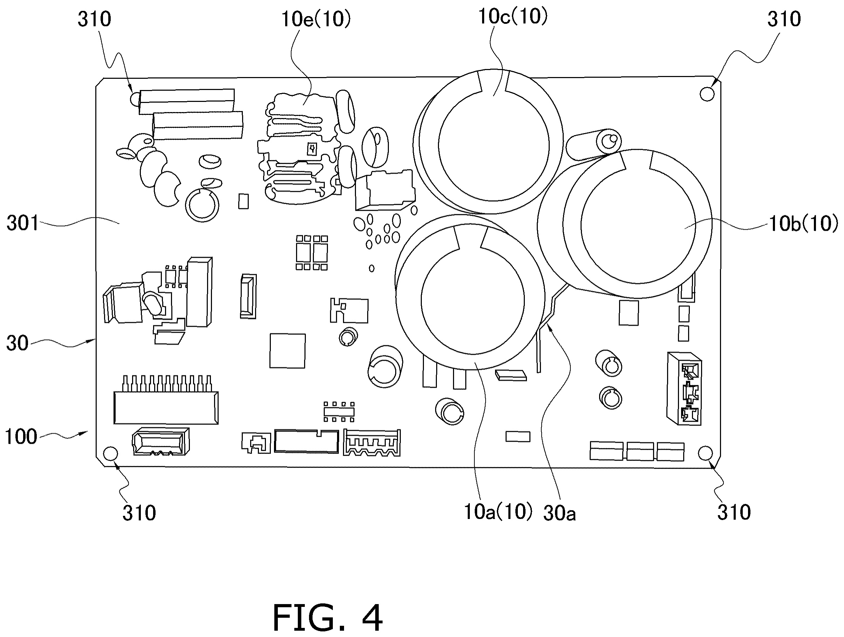

FIG. 4 is an external view of the printed circuit board 100 when the printed circuit board 100 shown in FIG. 3 is viewed from a direction in which the first surface 301 is a front surface.

In FIGS. 3 and 4, a substrate 30 is a printed wiring board. The substrate 30 has the first surface 301 as a component mounting surface on a front face. The substrate 30 has a second surface 302 as a component mounting surface on a reverse face.

### (2-1) First component 10 mounted on first surface 301

In FIG. 4, the first to third electrolytic capacitors 10a to 10c and the coil 10e are mounted as a first component 10 on the first surface 301 of the substrate 30.

Here, the second electrolytic capacitor 10b and the third electrolytic capacitor 10c are arranged counterclockwise from the first electrolytic capacitor 10a located substantially at a center of the substrate 30.

The first to third electrolytic capacitors 10a to 10c store electric energy by applying a voltage between terminals. The coil 10e stores inductive energy when a current flows.

The weight of each of the first to third electrolytic capacitors 10a to 10c and coil 10e is larger than the weight of other components mounted on the first surface 301 of the substrate 30, and is generally known as a heavy component.

Therefore, the first component 10 is defined as a heavy component that accumulates electric energy or inductive energy. In addition to the electrolytic capacitor and the coil, a reactor and a transformer also correspond to the first component 10. The reactor 10d shown in the circuit diagram of FIG. 2 is not provided on the substrate 30 and is not shown in FIG. 4, but is a heavy component that accumulates inductive energy.

### (2-2) Second component 20 mounted on second surface 302

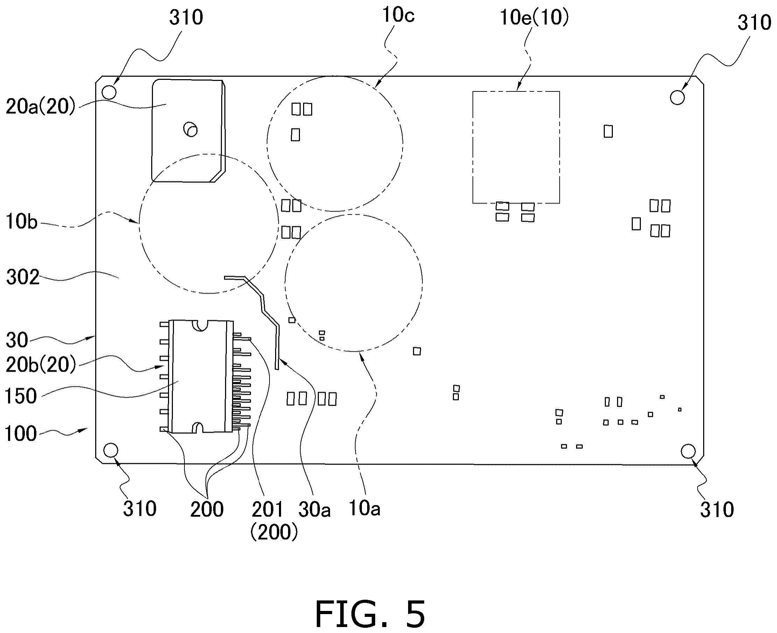

FIG. 5 is an external view of the printed circuit board 100 when the printed circuit board 100 shown in FIG. 3 is viewed from a direction in which the second surface 302 is the front surface.

In FIG. 5, three circles drawn by two-dot chain lines indicate the positions of the first to third electrolytic capacitors 10a to 10c mounted on the first surface 301. A square frame drawn by a two-dot chain line indicates the position of the coil 10e mounted on the first surface 301.

On the second surface 302 of the substrate 30, the rectifying diode module 20a and the IPM 20b are mounted as the second component 20.

The rectifying diode module 20a and the IPM 20b include a plurality of leads. For example, as shown in FIG. 5, the IPM 20b includes a package portion 150 and a plurality of leads 200 protruding from the package portion 150.

The rectifying diode module 20a and the IPM 20b are semiconductor elements used for power supply, and are generally known as power devices.

Therefore, the second component 20 is defined as a power device including a plurality of leads. In addition to the rectifying diode module and the IPM, an active filter module, an insulated gate bipolar transistor, a thyristor, and a triac also correspond to the second component 20.

As shown in FIGS. 4 and 5, in the substrate 30, a slit 30a is provided between the first to third electrolytic capacitors 10a to 10c and the IPM 20b. The function of the slit 30a will be described later in the section of "(4) Function of slit".

### (3) Fixing printed circuit board 100 to electric component box 70

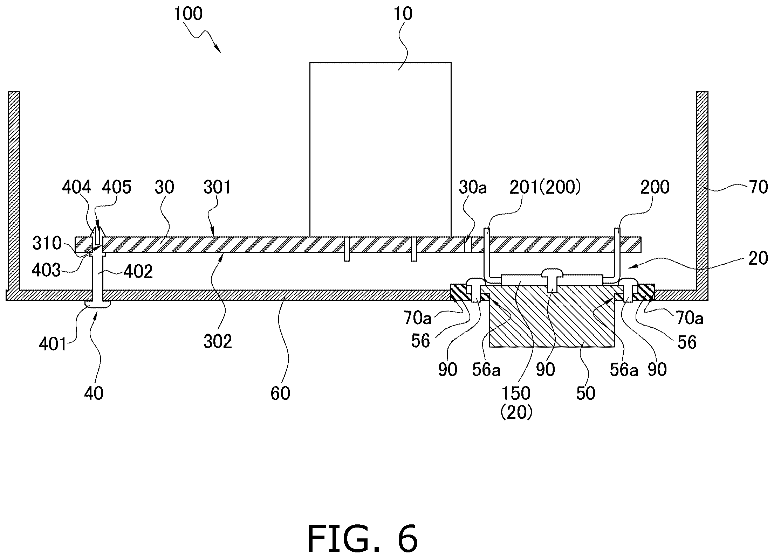

FIG. 6 is a schematic sectional view of the electric component box 70 which accommodates the printed circuit board 100 in FIG. 3. In FIG. 6, the first component 10 corresponds to the first electrolytic capacitor 10a, and the second component 20 corresponds to the IPM 20b.

As shown in FIG. 6, the printed circuit board 100 is fixed such that the second surface 302 faces a wall 60 of the electric component box 70 and the second surface 302 is separated from a wall surface of the wall 60 by a predetermined distance. The predetermined distance is set such that the component mounted on the second surface 302 and a metal member penetrating and protruding from the first surface 301 through the second surface 302 do not interfere with the wall 60.

### (3-1) Coupling member 40

In order to maintain the distance between the printed circuit board 100 and the wall 60 of the electric component box 70 at the predetermined distance, a coupling member 40 is attached to a corner of the printed circuit board 100. The coupling member 40 is made of resin. The coupling member 40 has a rod shape and includes a head 401, a body 402, a positioning portion 403, a disengagement stopper 404, and a groove 405.

The coupling member 40 is driven from the outside toward the inside of the wall 60 of the electric component box 70 until the head 401 hits an outer surface of the wall 60. The positioning portion 403 protrudes in a radial direction from an outer periphery of the body 402.

The disengagement stopper 404 is substantially conical and is located at an end of the body 402. The groove 405 is formed from a distal end of the drop-off preventing member 404 toward the positioning portion 403. The distance between the positioning portion 403 and the disengagement stopper 404 is slightly larger than the plate thickness of the substrate 30.

A holding hole 310 for inserting the drop-off preventing member 404 of the coupling member 40 is provided in advance at each of the four corners of the printed circuit board 100.

The holding hole 310 is placed so as to overlap the distal end of the disengagement stopper 404, and the printed circuit board 100 is pushed toward the positioning portion 403. At this time, the distal end of the drop-off preventing member 404 is bent in such a direction as to narrow the width of the groove 405, and a periphery of the holding hole 310 is accommodated between the positioning portion 403 and the drop-off preventing member 404. As a result, the printed circuit board 100 is fixed to the electric component box 70.

### (3-2) Heat sink 50

However, not all the four corners of the printed circuit board 100 are fixed to the electric component box 70 via the coupling member 40.

Since the second component 20 such as the IPM 20b generates a larger amount of heat than other mounted components, as shown in FIG. 6, a heat sink 50 for heat dissipation is attached to a surface not facing the second surface 302 by screws 90.

Since the second component 20 is located closer to a corner of the second surface 302 than the other mounted components, the second component 20 with the heat sink 50 is used as a member for positioning and coupling the substrate 30 with respect to the electric component box 70.

The heat sink 50 attached to the second component 20 is fixed to the electric component box 70 in a state that the electric component box 70 is penetrating. However, the heat sink 50 is not directly fixed to the electric component box 70, but an insulator 56 is interposed between the heat sink 50 and the electric component box 70.

The insulator 56 is made of resin. The wall 60 of the electric component box 70 is provided with a hole 70a into which the insulator 56 is inserted. The insulator 56 has an annular shape so as to cover an edge of the hole 70a from the inside of the hole 70a.

The annular insulator 56 is provided with a hole 56a into which the heat sink 50 is inserted. The heat sink 50 penetrates the hole 56a and is exposed to the outside of the electric component box 70. The heat sink 50 and the insulator 56 are fastened by the screws 90.

As described above, the second component 20 and the heat sink 50 function as coupling members for fixing the printed circuit board 100 to the electric component box 70.

### (4) Function of slit

As described above, in the IPM 20b as the second component 20, the leads 200 are soldered to the substrate 30, and the package portion 150 is fixed to the electric component box 70 via the heat sink 50. Therefore, the IPM 20b is not easily displaced from both the substrate 30 and the electric component box 70.

For example, when vibration is applied in a direction perpendicular to the substrate 30 (plate thickness direction) and the first component 10, which is a heavy component, vibrates, the vibration propagates to other mounted components on the substrate 30.

Since the IPM20b is not easily displaced from both the substrate 30 and the electric component box 70, a large stress repeatedly acts as compared with other mounted components. In particular, the lead 200 having weaker strength than the package portion 150 can be broken.

Therefore, in the present embodiment, as shown in FIGS. 4 to 6, the slit 30a is provided between the first component 10 and the second component 20 of the substrate 30. The slit 30a suppresses propagation of vibration from the heavy first component 10 to the second component 20, thereby preventing the lead 200 from breaking due to the vibration.

Specifically, as shown in FIG. 5, among the plurality of leads 200 of the IPM 20a, the lead closest to the first to third electrolytic capacitors 10a to 10c which are the first component 10 is defined as the first lead 201. Then, the slit 30a is provided between the first lead 201 and the first to third electrolytic capacitors 10a to 10c.

The width of the slit 30a is desirably in a range of 1.0 mm to 4.0 mm in consideration of both workability and prevention of vibration propagation.

The slit 30a preferably penetrates the substrate 30. In this case, propagation of vibration from the first component 10 is blocked by the penetrating slit 30a, and propagation to the second component 20 is suppressed.

### (4-1) Length of slit

The slit does not necessarily have a length that covers between all the first components (the first to third electrolytic capacitors 10a to 10c and the coil 10e) and the second component 20.

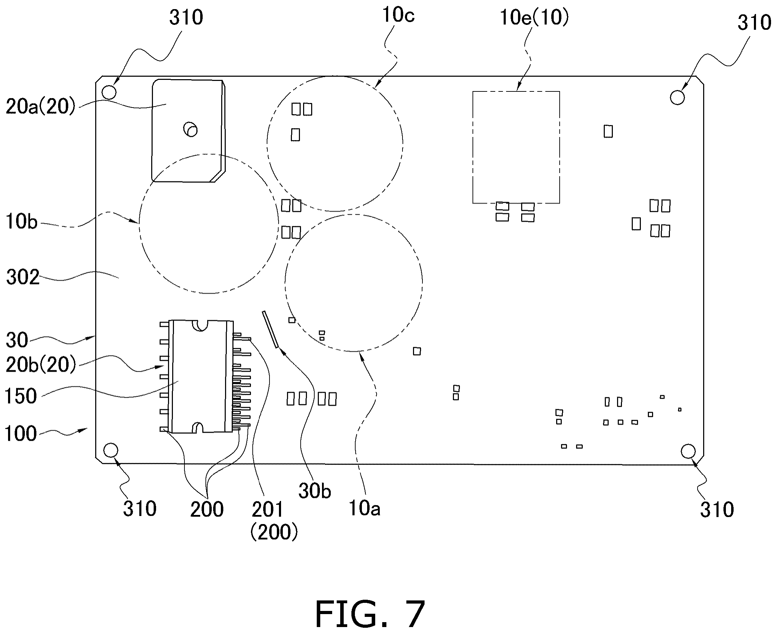

FIG. 7 is an external view of the second surface 302 of the printed circuit board 100 in which the length of the slit in FIG. 5 is changed.

In FIG. 7, a slit 30b is provided between the first electrolytic capacitor 10a located at a central portion of the substrate 30 and the first lead 201 which is the lead closest to the first electrolytic capacitor 10a. Therefore, the slit 30b has a shorter length than the slit 30a shown in FIG. 5, and is set to have a length that suppresses only vibration propagation from the first electrolytic capacitor 10a.

An experiment by the applicant has a result that an effect equivalent to the effect of the slit 30a shown in FIG. 5 is obtained by the slit 30b. Since a vibration amplitude of the first component (first electrolytic capacitor 10a) at the central portion of the substrate 30 in the first component 10 is the largest, it is considered that a maximum effect was exhibited by suppressing the propagation of vibration from the first electrolytic capacitor 10a. The length of the slit is desirably from 15 mm to 30 mm.

### (4-2) Number and position of slits

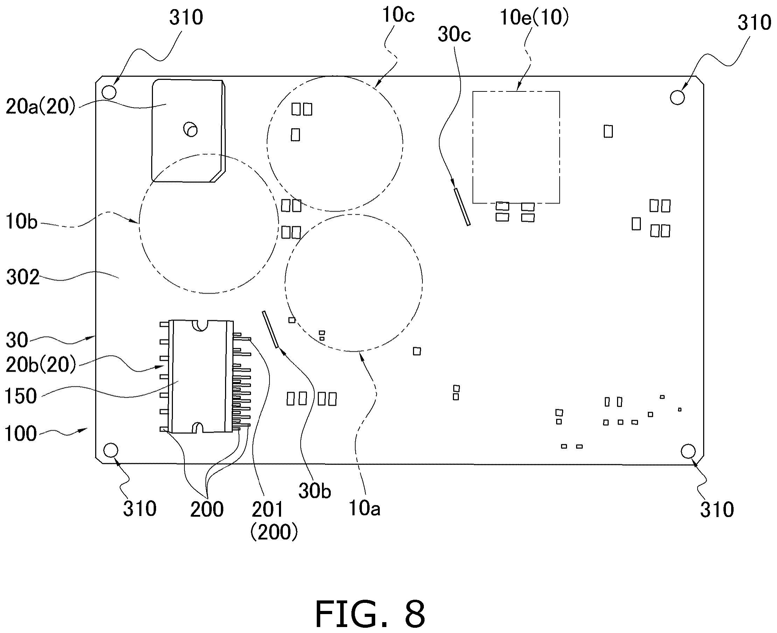

FIG. 8 is an external view of the second surface 302 of the printed circuit board 100 in which the number of the slits in FIG. 7 is changed.

In FIG. 8, a slit 30c is added near the coil 10e between the coil 10e, which is the first component 10 farthest away from the IPM 20b, and the first lead 201 of the IPM 20b and.

It has been found from the experiments by the applicant that the vibration propagation from the coil 10e farthest from the IPM20b may be larger than the vibration propagation from the first electrolytic capacitor 10a located at the central portion of the substrate 30 where the vibration amplitude is maximized.

This finding is presumed to be affected by a weight balance between the coil 10e and the first to third electrolytic capacitors 10a to 10c. In such a case, by providing the slit 30c so as to be close to the coil 10e, which is a vibration source, propagation of vibration from the coil 10e can be effectively suppressed.

### (5) Characteristics

(5-1)
   A printed circuit board 100 includes the first component 10 that is a heavy component that accumulates electric energy or inductive energy, the second component 20 that is a power device having the plurality of leads 200, and the substrate 30 on which the first component 10 and the second component 20 are mounted. In the substrate 30, the slit (30a, 30b, 30c) is provided between the first component 10 and the second component 20, and the leads 200 of the second component 20 are soldered. In the printed circuit board 100, the slit (30a, 30b, 30c), which suppresses propagation of vibration from the heavy first component 10 to the second component 20, thereby preventing the leads 200 from breaking due to the vibration.
(5-2)
   Among the plurality of leads 200 of the second component 20, the slit (30a, 30b, 30c) is provided between the first lead 201 closest to the first component 10 and the first component 10.
(5-3)
   When vibration in a direction perpendicular to the substrate 30 is applied, stress on the first lead 201 by the first component 10 is larger than stress on another component.
(5-4)
   Among the plurality of first components 10, the slit (30a, 30b, 30c) is provided between the second component 20 and the first component 10 having the largest stress on the lead 200 when vibration in the direction perpendicular to the substrate 30 is applied.
(5-5)
   The first component 10 is any of an electrolytic capacitor, a reactor, or a coil.
(5-6)
   The second component 20 is any of an intelligent power module, an active filter module, an insulated gate bipolar transistor, a thyristor, or a triac.
(5-7)
   In the printed circuit board 100, since the first component 10 is located at the central portion of the substrate 30, the substrate 30 is easily distorted by vibration. Therefore, providing the slit (30a, 30b) in the substrate 30 is highly effective.
(5-8)
   The slit 30a, 30b, 30c penetrates the substrate 30.
(5-9)
   When the width of the slit 30a, 30b, 30c is within a range of 1.0 mm to 4.0 mm, both workability and prevention of vibration propagation can be satisfied.
(5-10)
   The substrate 30 is fixed to the object via the coupling member 40 and the second component 20. Since the lead 200 of the second component 20 also functions as a coupling member, the second component 20 is susceptible to repeated fatigue due to vibration as compared with other mounted components. Therefore, the slit (30a, 30b, 30c) is provided between the first component 10 and the second component 20 to block vibration propagation and protect the lead 200 from repeated fatigue.

While the embodiment according to the present disclosure has been described above, it will be understood that various changes in forms and details can be made without departing from the gist and scope of the present disclosure recited in the claims.

### INDUSTRIAL APPLICABILITY

The slit of the present disclosure can be applied not only to a printed circuit board mounted on an outdoor unit, but also to a printed circuit board mounted on an indoor unit of an air conditioner, a printed circuit board mounted on a refrigeration apparatus other than an air conditioner, and a printed circuit board mounted on electric equipment.

### REFERENCE SIGNS LIST

- 1: air conditioner
- 10: first component
- 10a: first electrolytic capacitor (first component)
- 10b: second electrolytic capacitor (first component)
- 10c: third electrolytic capacitor (first component)
- 10d: reactor (first component)
- 10e: coil 10e (first component)
- 20: second component
- 20a: rectifying diode module (second component)
- 20b: intelligent power module (IPM; second component)
- 30: substrate
- 30a: slit
- 30b: slit
- 30c: slit
- 40: coupling member
- 70: electric component box (object)
- 100: printed circuit board
- 200: lead
- 201: first lead

### CITATION LIST

### PATENT LITERATURE

Patent Literature 1: JP H4-107875 U

## Claims

1. A printed circuit board (100) comprising:
a first component (10) that is a heavy component that accumulates electric energy or inductive energy;
a second component (20) that is a power device including a plurality of leads (200); and
a substrate (30) on which the first component (10) and the second component (20) are mounted, in which a slit (30a, 30b, 30c) is provided between the first component (10) and the second component (20), and to which the leads (200) of the second component (20) are soldered.

2. The printed circuit board (100) according to claim 1, wherein
the plurality of leads (200) includes a first lead (201) closest to the first component (10), and
the slit (30a, 30b, 30c) is provided between the first component (10) and the first lead (201).

3. The printed circuit board (100) according to claim 2, wherein
stress applied to the first lead (201) by the first component (10) is larger than stress applied to another component when vibration is applied in a direction perpendicular to the substrate (30).

4. The printed circuit board (100) according to any one of claims 1 to 3, wherein
a plurality of the first components (10) are mounted on the substrate (30),
the plurality of first components (10) includes a first heavy component having a largest stress on the leads (200) when the vibration in the direction perpendicular to the substrate (30) is applied, and
the slit (30a, 30b, 30c) is provided between the first heavy component and the second component (20).

5. The printed circuit board (100) according to any one of claims 1 to 4, wherein
the first component (10) is any of an electrolytic capacitor, a reactor, or a coil.

6. The printed circuit board (100) according to any one of claims 1 to 5, wherein
the second component (20) is any of an intelligent power module, an active filter module, an insulated gate bipolar transistor, a MOSFET, a diode, a thyristor, or a triac.

7. The printed circuit board (100) according to any one of claims 1 to 6, wherein
the first component (20) is mounted at a central portion of the substrate (30).

8. The printed circuit board (100) according to any one of claims 1 to 7, wherein
the slit (30a, 30b, 30c) penetrates the substrate (30).

9. The printed circuit board (100) according to any one of claims 1 to 8, wherein
a width of the slit (30a, 30b, 30c) is in a range of 1.0 mm to 4.0 mm.

10. The printed circuit board (100) according to any one of claims 1 to 9, wherein
the substrate (30) is fixed to an object (70) via a coupling member (40) and the second component (20).

11. An air conditioner (1) comprising
the printed circuit board (100) according to any one of claims 1 to 10.
